# EUROPÄISCHE PATENTSCHRIFT

(11) **EP 3 267 416 B1**
(45) Veröffentlichungstag und Bekanntmachung des Hinweises auf die Patenterteilung: **31.08.2022**
(21) Anmeldenummer: 17179809.3
(22) Anmeldetag: 05.07.2017
(51) Int. Cl.: G08C 17/00

(54) **FERNSTEUERUNG**
REMOTE CONTROL
TÉLÉCOMMANDE

(30) Priorität: 05.07.2016 DE 102016112318
(43) Veröffentlichungstag der Anmeldung: 10.01.2018
(73) Patentinhaber: fm marketing gmbh, 5202 Neumarkt am Wallersee (AT)
(72) Erfinder: FISCHER, Thomas, 83457 Bayerisch Gmain (DE); MAIER, Ferdinand, 5202 Neumarkt am Wallersee (AT)
(74) Vertreter: von Bülow & Tamada

(56) Entgegenhaltungen:
- EP-A2- 2 112 825
- WO-A1-2010/119348
- DE-A1- 2 516 171
- DE-A1-102010 019 596

## Beschreibung

Die Erfindung bezieht sich auf eine Fernsteuerung. Fernsteuerungen, bei denen Eingabeelemente wie Tasten durch Magnete mit haptisch wahrnehmbaren Kräften beaufschlagt werden, sind beispielsweise aus der DE 10 2011 014763 A1, DE 10 2010 019596 A1, EP 2568369 A1 oder WO 2010/119348 A1 bekannt.

In der älteren nicht vorveröffentlichten DE 10 2015 119485 ist eine Fernbedienung mit Magneten beschrieben, die eine durch einen Benutzer drückbare Taste zum Einlesen von Informationen durch Druck des Benutzers in einer Druckrichtung, einen in der Druckrichtung gesehen an der Unterseite der Taste befestigten Gebermagneten und einen in der Druckrichtung gesehen unterhalb der Taste und gegenüber der Taste ortsfest angeordneten Ankermagneten aufweist, wobei die Magnetpole des Gebermagneten und des Ankermagneten derart angeordnet sind, dass die Taste mit dem Gebermagneten von dem Ankermagneten weg gegen die Druckrichtung gedrückt wird.

Die DE 10 2010 019 596 A1 und EP 2 112 825 A2 offenbaren je eine Fernsteuerung gemäß dem Oberbegriff des geltenden Anspruchs 1.

Die DE 25 16 171 A1 offenbart einen optisch-elektronischen Tastschalter - wobei am Tastschalter mehrere Zapfen mit verdicktem Kopf befestigt sind, eine Tragplatte an die verdickten Köpfe angepasste Lagerschalen aufweist, wobei sich die Zapfen durch Öffnungen der Tragplatte hindurch erstrecken und die Lageschalen und die verdickten Köpfe als Begrenzungsanschlag für eine Bewegung der des Tastschalters entgegen einer Druckrichtung ausgebildet sind.

Mit der vorliegenden Erfindung soll eine Fernsteuerung geschaffen werden, bei der zumindest eine der Tasten präzise am Gehäuse der Fernsteuerung gehalten, ausgerichtet und geführt ist. Dies soll insbesondere weitest gehend spielfrei erfolgen.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Die Grundidee der Erfindung liegt darin, dass eine Multifunktionstaste mit mehreren Tastenbereichen in einer ersten Richtung zur Außenseite des Gehäuses fortgedrückt wird. Zur Lagerung, Führung, Zentrierung und Ausrichtung der Multifunktionstaste sind an ihr mehrere Zapfen mit verdicktem Kopf befestigt, wobei eine gehäusefeste Tragplatte Lagerschalen aufweist, an die die verdickten Köpfe angepasst sind. Die Zapfen erstrecken sich durch Öffnung der Tragplatte hindurch und die Lagerschalen in Kombination mit den verdickten Köpfen sind als Führung und Begrenzungsanschlag für eine Bewegung der Multifunktionstaste ausgebildet.

Vorzugsweise hat die Multifunktionstaste mehreren radial gegenüber dem Mittelpunkt versetzt angeordnete Tastenbereiche, die mehrere Magnete aufweisen, denen mit dem Gehäuse verbundene Gegenmagnete zugeordnet sind. Magnete und Gegenmagnete sind so polarisiert und angeordnet, dass die Multifunktionstaste in einer ersten Richtung zur Außenseite des Gehäuses fortgedrückt wird.

Vorzugsweise ist die Multifunktionstaste als Kreisring ausgebildet. Sie kann aber auch als Druckkreuz oder als Dreieck ausgebildet sein.

Die verdickten Köpfe sind vorzugsweise kugelsegmentförmig. Vorzugsweise sind die Zapfen in Hülsen an der Multifunktionstaste befestigt und zwar vorzugsweise angeklebt.

Weiter sind vorzugsweise die Magnete und die Zapfen jeweils am radial äußeren Bereich der Multifunktionstaste angeordnet und jeweils in äquidistanten Abständen tangential gegeneinander versetzt angeordnet, wobei die Magnete und die Zapfen ihrerseits ebenfalls gegeneinander versetzt angeordnet sind.

Nach einer Weiterbildung der Erfindung ist die Tragplatte an einer Leiterbahnplatte befestigt, wobei die Leiterbahnplatte in dem Gehäuse der Fernbedienung gehalten ist.

Im Folgenden wird die Erfindung anhand eines Ausführungsbeispiels im Zusammenhang mit der Zeichnung ausführlicher erläutert.

Es zeigt:
Fig. 1 eine Draufsicht einer Fernsteuerung nach der Erfindung;
Fig. 2 einen Draufsicht auf eine Multifunktionstaste der Fernsteuerung der Fig. 2 bei fortgelassener Oberschale;
Fig. 3 einen Schnitt längs der Linie B-B der Fig. 2;
Fig. 4 einen Schnitt längs der Linie C-C der Fig. 2;
Fig. 5 einen Schnitt längs der Linie A-A der Fig. 2;
Fig. 6 vergrößerte Darstellung der Einzelheit Y der Fig. 5;
Fig. 7 eine vergrößerte Abbildung der Einzelheit Z der Fig. 5;
Fig. 8 eine Ansicht der Unterseite der Multifunktionstaste der Fig. 2; und
Fig. 9 eine Explosionsdarstellung der Multifunktionstaste.

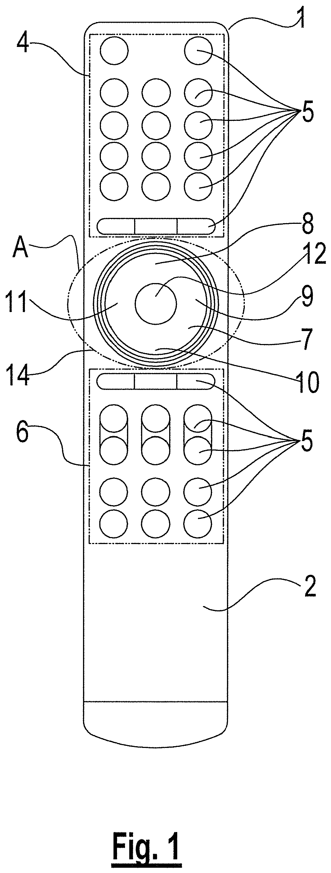

Die Fernsteuerung der Fig. 1 umfasst ein Gehäuse 1, das aus einer Oberschale 2 und einer Unterschale 3 zusammengesetzt ist, sowie ein erstes Tastenfeld 4 mit einer Vielzahl von Tasten 5 und ein zweites Tastenfeld 6 mit einer Vielzahl von Tasten 5, wobei der Übersichtlichkeit halber nicht alle Tasten in den Tastenfeldern 4 und 6 mit einem Bezugszeichen versehen sind.

Zwischen den beiden Tastenfeldern 4 und 6 ist eine Multifunktionstaste 7 angeordnet, die hier vier Tastenbereiche 8, 9, 10 und 11 aufweist, die durch Niederdrücken in Zusammenwirken mit Sensoren oder Schaltern bestimmte Signale auslösen, mit denen ein nicht dargestelltes Multimediagerät, wie zB ein Fernsehgerät, bedient werden kann. Es sei betont, dass die Multifunktionstaste an beliebiger Stelle gedrückt werden kann und nicht nur an den genannten vier Tastenbereichen 8 - 11. Es wird dann ein entsprechender x,y-Wert zurückgegeben oder auch ein r/phi-Wert im Polarkoordinatensystem. Dabei wird dann angezeigt, in welcher Richtung wir tief gedrückt wurde. Die Multifunktionstaste 7 ist hier als Kreisring dargestellt, wobei die Tastenbereiche 8-11 radial gegenüber dem Mittelpunkt des Kreisringes versetzt und tangential in äquidistanten Abständen angeordnet sind. Bei den hier dargestellten vier Tastenbereichen sind diese um 90° gegeneinander tangential versetzt. Es sind aber auch Konfigurationen mit mehr als vier Tastenbereichen möglich oder auch Konfigurationen mit nur drei Tastenbereichen.

Anstelle eines Kreisringes kann die Multifunktionstaste 7 auch als Steuerkreuz ausgebildet sein, das beispielsweise vier Arme hat. Wird einer der Tastenbereiche 8-11 oder eine sonstige Stelle der Multifunktionstaste vom Benutzer niedergedrückt, also in Richtung auf das Innere des Gehäuses 1, so wird dies von im Inneren des Gehäuses angeordneten Sensoren und einer Elektronik erfasst und ausgewertet.

Im hier dargestellten Ausführungsbeispiel, bei dem die Multifunktionstaste 7 als Kreisring ausgebildet ist, kann im Inneren des Kreisringes eine kreisförmige Bestätigungstaste 12 angeordnet sein.

Weiter können auf der Fernsteuerung Anzeigemittel, wie beispielsweise kleine Lämpchen, vorhanden sein, mit denen einem Benutzer der Fernsteuerung ein Funktionszustand der Fernsteuerung angezeigt werden kann.

Nachstehend wird die Erfindung anhand des Bereiches A der Fig. 1, in dem die Multifunktionstaste 7 angeordnet ist, näher erläutert. Dies soll jedoch nicht einschränkend verstanden werden, denn grundsätzlich lassen sich die nachstehend ausgeführten Merkmale auch auf jede beliebige Taste 5 in den Tastenfeldern 4 und 6 übertragen.

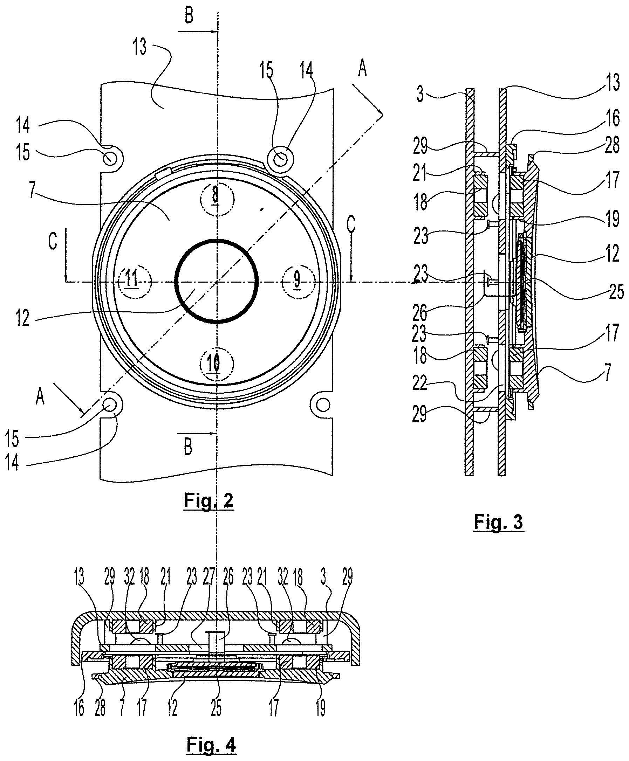

Fig. 2 zeigt eine Draufsicht auf die Multifunktionstaste 7, wobei die Oberschale 2 und die Unterschale 3 fortgelassen sind. Die Multifunktionstaste 7 ist hier als Kreisring ausgebildet, in dessen Zentrum die kreisförmige Bestätigungstaste 12 angeordnet ist. Wie noch näher erläutert werden wird, ist die Multifunktionstaste 7 gegenüber einer ortsfest im Gehäuse 1 angeordneten Leiterbahnplatte 13 verschiebbar und zwar jeweils wahlweise auch nur mit einem der Tastenbereiche 8-11, der in das Innere des Gehäuses 1 bewegt werden kann und durch Magnetkräfte oder Federkräfte nach außen gedrückt wird, wobei eine Verschiebung nach innen und nach außen jeweils begrenzt ist. Drückt der Benutzer nur einen der Tastenbereiche 8-11, so wird die Multifunktionstaste 7 gegenüber der Ebene der Leiterbahnplatte 13 leicht gekippt, wobei der gedrückte Tastenbereich weiter nach innen in das Gehäuse 1 kommt und somit näher an die Leiterbahnplatte 13 als die nicht gedrückten Tastenbereiche.

In Fig. 2 ist noch zu erkennen, dass die Leiterbahnplatte 13 mehrere Öffnungen oder Aussparungen 14 aufweist, durch welche Zapfen 15 der Unterschale 3 hindurchragen, die in Hülsen der Oberschale 2 eingreifen, um Oberschale 2 und Unterschale 3 miteinander zu verbinden. Diese Art der Verbindung ist näher in der EP 2620044 A1 beschrieben. Alternativ oder zusätzlich können die Unterschale 3 und die Oberschale 2 auch miteinander verklebt, verschraubt oder anderweitig dauerhaft miteinander verbunden werden.

Bei der vorliegenden Erfindung geht es im wesentlichen um die Lagerung der Multifunktionstaste 7, was im Zusammenhang mit den weiteren Figuren 3 bis 9 beschrieben wird.

Generell ist die Multifunktionstaste 7 zusammen mit der Bestätigungstaste 12 an einer Tragplatte 16 gehalten. Die Bestätigungstaste 12 ist mit der Multifunktionstaste 7 verbunden, kann jedoch in begrenztem Unfang zur Betätigung relativ zur Multifunktionstaste 7 bewegt werden. Die Tragplatte 16 ihrerseits kann fest mit der Leiterbahnplatte 13 verbunden sein, beispielsweise durch Kleben. Die Tragplatte 16 kann jedoch auch in anderer Weise relativ zur Leiterbahnplatte 13 ortsfest gehalten sein. Die Einheit aus Multifunktionstaste 7 und Bestätigungstaste 12 ist relativ zu der Tragplatte 16 verschiebbar und zwar im wesentlichen senkrecht zur Ebene der Leiterbahnplatte 13.

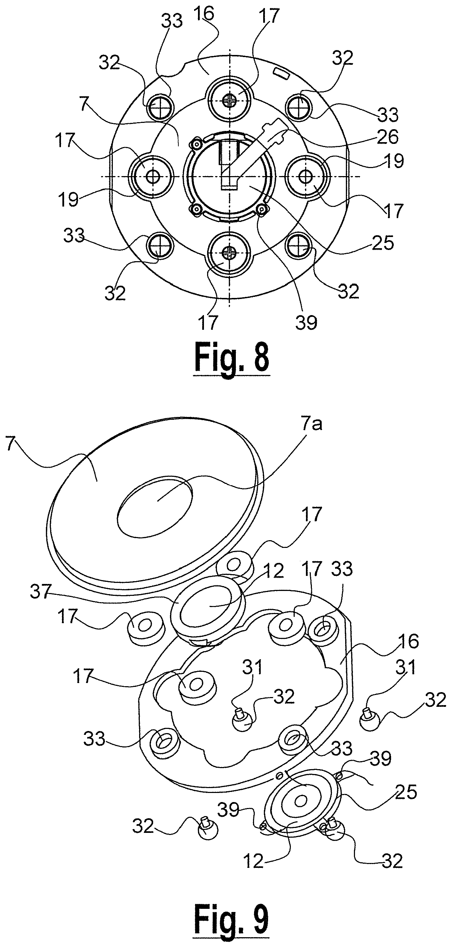

Die Tragplatte 16 hat im wesentlichen die Form eines Kreisringes (mit Aussparungen Fig. 9), dessen Durchmesser etwas größer ist als der Durchmesser der Multifunktionstaste 7, sofern diese als Kreisring ausgebildet ist. Andere Formen von Multifunktionstaste und Tragplatte sind ebenfalls möglich.

An der Multifunktionstaste 7 sind mehrere Magnete 17 befestigt, die in Umfangsrichtung in äquidistanten Abständen angeordnet sind und sich nahe dem Außenumfang der Multifunktionstaste 7 befinden. Die Magnete können nahe den Tastenbereichen 8-11 angeordnet sein. Andere Anordnungen der Magnete sind jedoch auch möglich. Diese Magnete 17 sind mit der Multifunktionstaste 7 verbunden und in Hülsen 19 der Multifunktionstaste 7 befestigt. Die Magnete 17 sind also zusammen mit der Multifunktionstaste 7 verschiebbar.

An der Unterschale 3 (Fig. 3) des Gehäuses 1 der Fernbedienung sind den Magneten 17 zugeordnete Gegenmagnete 18 in Hülsen 21 der Unterschale 3 befestigt. Jeder Gegenmagnet 18 ist jeweils einem der Magnete 17 zugeordnet. Die Magnete 17 und die Gegenmagnete 18 sind so polarisiert und angeordnet, dass sich jeweils Magnet 17 und Gegenmagnet 18 gegenseitig abstoßen, womit auf die Multifunktionstaste 7 eine Magnetkraft ausgeübt wird, die die Multifunktionstaste 7 in Richtung zur Außenseite der Oberschale 2 des Gehäuses 1 drückt. Die jeweiligen Paare von Magnet 17 und Gegenmagnet 18 sind vorzugsweise an den Tastenbereichen 8-11 der Multifunktionstaste 7 angeordnet.

Die Leiterbahnplatte 13 hat an den Bereichen der Magnete 17 jeweils eine Öffnung 22, durch die der Magnet 17 beim Niederdrücken eines Bereiches der Multifunktionstasten 7 näher zu dem Gegenmagnet 18 gebracht wird. Jeweils nahe neben der Öffnung 22 ist ein Sensor 23 angeordnet, der die Position der Magnete erfasst, zb durch Erfassen der Magnetfeldlinien der Magnete 17 und der Gegenmagnete 18, und einer auf der Leiterbahnplatte 13 angeordneten (nicht dargestellten) Auswerteelektronik zuleitet. Die Sensoren 23 können beispielsweise Spulen sein. Es ist offensichtlich, dass sich der Magnetfluss der Paare von Magnet 17 und Gegenmagnet 18 beim Niederdrücken ändert, sodass das von dem Sensor 23 erfasste Signal den Abstand zwischen Magnet 17 und Gegenmagnet 18 erfassen lässt und ebenso auch die Geschwindigkeit des Niederdrückens der Multifunktionstaste 7.

Die Leiterbahnplatte 13 ist durch eine Vielzahl von Rippen 29 im Abstand zu der Unterschale 3 gehalten. Der Abstand kann konstant sein. Es is aber auch ein nicht konstanter Abstand möglich Die Rippen 29 sind einstückig an der Unterschale 3 angeformt und dienen auch der Versteifung des Gehäuseunterteils.

Aus den Figuren 3 und 4 ist noch zu erkennen, dass die Bestätigungstaste 12 als Schalter ausgebildet ist, der eine Unterschale 25 aufweist, die an der Multifunktionstaste 7 befestigt ist, so dass die Bestätigungstaste 12 relativ zur Multifunktionstaste 7 bewegt werden kann. Ein elektrischer Anschluss 26 der Bestätigungstaste 12 ist durch eine Öffnung 27 der Leiterbahnplatte 13 hindurchgeführt und in nicht weiter dargestellter Weise mit elektronischen Schaltkreisen auf der Leiterbahnplatte 13 verbunden.

Schließlich zeigen die Figuren 3 und 4 noch, dass an dem Außenumfang der Multifunktionstasten 7 ein Zier- oder Markierungsring 28 angebracht ist.

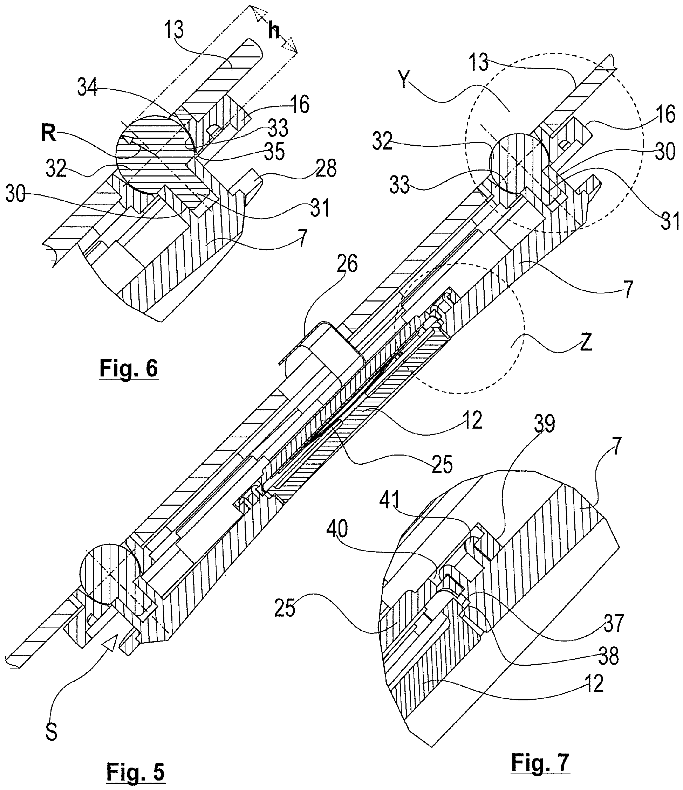

Im folgenden wird unter Bezugnahme auf die Figuren 5-9 auf die Halterung, Zentrierung und Lagerung der Multifunktionstaste 7 näher eingegangen.

Zur Führung, Halterung und Ausrichtung der Multifunktionstaste 7 sind an ihrer zur Leiterbahnplatte 13 weisenden Unterseite mehrere Hülsen 30 vorgesehen, in die Zapfen 31 eingesteckt und fest mit den Hülsen 30 verbunden sind, beispielsweise durch Kleben. Die Zapfen 31 haben jeweils einen verdickten Kopf 32, der vorzugsweise die Form eines Kugelsegmentes hat. Die Höhe h des Kugelsegmentes ist dabei größer als der Radius r der Kugel. (vgl. Fig. 6)

Die Tragplatte 16 hat den Zapfen 31 zugeordnete Öffnungen 35 mit an der der Multifunktionstaste 7 abgewandten Seite ausgebildeten Lagerschalen 33, die an die Form des verdickten Kopfes 32 angepasst sind und eine sich vergrößernde trichterförmige Öffnung 34 aufweisen.

Wird die Multifunktionstaste 7 durch die Magnetkräfte fort von der Leiterbahnplatte 13 gedrückt, so wirken die Köpfe 32 und die Lagerschalen 33 als Begrenzungsanschlag und gleichzeitig als Zentrierung für die Ausrichtung der Multifunktionstaste 7. In Gegenrichtung, also bei Niederdrücken durch einen Benutzer, ist die Bewegung der Multifunktionstaste 7 in Richtung auf die Leiterbahnplatte 13 zu dadurch begrenzt, dass die Unterseite der Multifunktionstaste 7 gegen die Tragplatte 16 anstößt. Der mögliche Hub der Multifunktionstaste 7 ist in Fig. 5 durch den Spalt S zwischen Unterseite der Multifunktionstaste 7 und Oberseite der Tragplatte 16 verdeutlicht. Beim Niederdrücken eines der Tastenbereiche 8 - 11 taucht der zugeordnete Magnet 17 in eine zugeordnete Öffnung 22 der Leiterbahnplatte 13 ein und nähert sich dem zugeordneten Gegenmagnet 18. Dadurch verändert sich das Magnetfeld von Magnet 17 und Gegenmagnet 18, was von zugeordneten Sensoren 23 erfasst wird. Die Sensoren 23 können beispielsweise Spulen sein, die an der zur Unterschale 3 weisenden Seite der Leiterbahnplatte 13 angebracht sind und zwar möglichst nahe an der Öffnung 22.

Wie am besten aus Figur 6 zu erkennen ist, hat die Lagerschale 33 auf ihrer zu der Multifunktionstaste 7 weisenden Seite eine kreisrunde Öffnung 35, deren Durchmesser größer ist als der Außendurchmesser der Hülse 30, damit auch ein "Kippen" der Multifunktionstaste 7 möglich ist, das ja dann auftritt, wenn einer der Tastenbereiche niedergedrückt wird, während die übrigen Tastenbereiche durch die Magnetkräfte weiterhin nach "außen", also von der Leiterbahnplatte 13 fort gedrückt werden.

Wie am besten aus Figur 7 zu erkennen ist, hat die als Schalter ausgebildete Bestätigungstaste 12 eine radial vorspringende Stufe 37, die an einer daran angepassten Stufe 38 der Multifunktionstaste 7 abgestützt ist, so dass ein Verschieben der Bestätigungstaste 12 nach "außen" über den von der Stufe 37 gebildeten Anschlag hinaus nicht möglich ist. Die Unterschale 25 der Bestätigungstaste 12 überdeckt radial die Bestätigungstaste 12 und hat mehrere Arme 39 mit Bohrungen 40, durch welche Verstemmzapfen 41 hindurchgesteckt und an der Oberseite der Arme 39 verstemmt sind, wobei diese Verstemmzapfen 41 einstückig mit der Multifunktionstaste 7 verbunden sind und von ihr senkrecht abstehen. Durch ein Verstemmen der Verstemmzapfen 41 wird also die Unterschale 25 an der Multifunktionstaste 7 fixiert. Zwischen der Bestätigungstaste 12 und der Unterschale 25 sind in bekannter Weise Schaltkontakte angeordnet, die mit dem elektrischen Anschluss 26 verbunden sind.

Figur 8 zeigt eine Draufsicht der Unterseite von Multifunktionstaste 7, Tragplatte 16 und Bestätigungstaste 12. Man erkennt die an der Multifunktionstaste 7 befestigten Magnete 17, die in den Hülsen 19 gehalten sind, sowie die verdickten Köpfe 32, die in den Lagerschalen 33 der Tragplatte 16 abgestürzt sind. Weiter sieht man die Unterschale 25 der Bestätigungstaste 12 sowie die Arme 39 und die Verstemmzapfen 41.

Figur 9 verdeutlicht die Montage der Multifunktionstaste. Zunächst werden die Magnete 17 an der Unterseite der Multifunktionstaste 7 in den Hülsen (19 Fig. 8) befestigt und die Bestätigungstaste 12 mit ihrem radial vorspringenden Rand 37 in die mittige Öffnung 7a der Multifunktionstaste 7 eingesetzt. Sodann wird die Unterschale 25 angefügt, wobei die Arme 39 an die Verstemmzapfen 41 an der Unterseite der Multifunktionstaste 7 angesetzt und verstemmt werden. Sodann werden die Zapfen 31 mit den verdickten Köpfen 32 durch die Lagerschalen 33 eingeführt und mit den zugeordneten Hülsen 19 an der Unterseite der Multifunktionstaste 7 verbunden womit gleichzeitig die Tragplatte 16 mit der Multifunktionstaste 7 verbunden wird. Die korrekte Lage und speziell der Abstand zwischen der Multifunktionstaste 7 und der Leiterplatte 13 wird durch die Dimensionierung der Hülsen 30, der verdickten Köpfe 32 und der Lagerschalen 33 bestimmt.

Die so montierte Multifunktionstaste wird dann relativ zur Leiterbahnplatte 13 ortsfest befestigt, z.B. indem die Tragplatte 16 an der Leiterbahnplatte 13 angeklebt wird.

### Bezugszeichen

1 Gehäuse
2 Oberschale
3 Unterschale
4 erstes Tastenfeld
5 Tasten
6 zweites Tastenfeld
7 Multifunktionstaste
8,9,10,11 Tastenbereiche
12 Bestätigungstaste
13 Leiterbahnplatte
14 Öffnungen
15 Zapfen (Verbindung 2 mit 3)
16 Tragplatte
17 Magnete
18 Gegenmagnete
19 Hülsen (für 17)
21 Hülsen (für 18)
22 Öffnung (für 17)
23 Sensor
24 Stifte (13 an 3)
25 Unterschale (von 12)
26 elektrischer Anschluss (von 12)
27 Öffnung (in 13 für 26)
28 Markierungsring
29 Rippen
30 Hülsen für Zapfen
31 Zapfen
32 Kopf
33 Lagerschalen
34 trichterförmige Öffnung
35 Öffnung für Zapfen
37 Stufe (an 12)
38 Oberseite (von 39)
39 Arme (an 25)
40 Bohrung (an 39)
41 Verstemmzapfen
S Spalt
R Radius (von 32)
h Höhe (von 32)

## Patentansprüche

1. Fernbedienung mit einem Gehäuse (1) und einer Multifunktionstaste (7), die mehrere radial gegenüber einem Mittelpunkt versetzt angeordnete Tastenbereiche (8, 9, 10, 11) aufweist, die relativ zum Gehäuse (1) bewegbar sind, wobei die Multifunktionstaste (7) mehreren radial gegenüber ihrem Mittelpunkt versetzt angeordnete Tastenbereiche (8, 9, 19, 11) aufweist, die mehrere Magnete (17) aufweisen, denen mit dem Gehäuse (1) verbundene Gegenmagnete (18) zugeordnet sind,
**dadurch gekennzeichnet, dass**
- die Magnete (17) und Gegenmagnete (18) so polarisiert und angeordnet sind, dass die Multifunktionstaste (7) in einer ersten Richtung zur Außenseite des Gehäuses (1) fortgedrückt ist,
- an der Multifunktionstaste (7) mehrere Zapfen (31) mit verdicktem Kopf (32) befestigt sind,
- eine gehäusefeste Tragplatte (16) an die verdickten Köpfe (32) angepasste Lagerschalen (33) aufweist,
- sich die Zapfen (31) durch Öffnungen (34) der Tragplatte (16) hindurch erstrecken
- und die Lageschalen (33) und die verdickten Köpfe (32) als Begrenzungsanschlag für eine Bewegung der Multifunktionstaste (7) entgegen der ersten Richtung ausgebildet sind.

2. Fernbedienung nach Anspruch 1, **dadurch gekennzeichnet, dass** die Multifunktionstaste (7) die Form eines Kreisringes hat.

3. Fernbedienung nach einem der Ansprüche 1, **dadurch gekennzeichnet, dass** die Multifunktionstaste (7) die Form eines Kreuzes hat.

4. Fernbedienung nach einem der Ansprüche 1-3, **dadurch gekennzeichnet, dass** die verdickten Köpfe (32) kugelsegmentförmig sind.

5. Fernbedienung einen Ansprüche 1-4, **dadurch gekennzeichnet, dass** die Zapfen (31) in Hülsen (30) der Multifunktionstaste (7) befestigt sind.

6. Fernbedienung einen Ansprüche 1-5, **dadurch gekennzeichnet, dass** an der Multifunktionstaste (7) vier Magnete (17) und vier Zapfen (31) mit verdicktem Kopf (32) angeordnet sind, wobei die Magnete (17) und die Zapfen (31) tangential gegeneinander versetzt sind.

7. Fernbedienung nach einem der Ansprüche 1-6, **dadurch gekennzeichnet, dass** die Tragplatte (16) an der Gehäuseoberseite (2) oder der Gehäuseunterseite (3) oder an einer Leiterbahnplatte (13) befestigt ist.

## Claims

1. Remote control with a housing (1) and a multifunction button (7) which has a plurality of button areas (8, 9, 10, 11) which are arranged radially offset with respect to a center point and movable relative to the housing (1), wherein the multifunction button (7) having plurality of button areas (8, 9, 19, 11) which are arranged radially offset with respect to their center point have a plurality of magnets (17) to which counter-magnets (18) are assigned connected to the housing (1),
**characterised in that**
- the magnets (17) and counter-magnets (18) are polarized and arranged such that the multifunction button (7) is pushed away in a first direction towards the outside of the housing (1),
- a plurality of pins (31) with thickened heads (32) are attached to the multifunction button (7),
- a housing-fixed carrying plate (16) has bearing shells (33) adapted to the thickened heads (32),
- the pins (31) extend through openings (34) in the carrying plate (16)
- and the bearing shells (33) and the thickened heads (32) are formed as a limiting stop for a movement of the multifunction button (7) against the first direction.

2. Remote control according to claim 1, **characterized in that** the multifunction button (7) has the shape of a circular ring.

3. Remote control according to one of the claims 1, **characterized in that** the multifunction button (7) has the shape of a cross.

4. Remote control according to any one of claims 1-3, **characterized in that** the thickened heads (32) are spherical segment-shaped.

5. Remote control according to any one of claims 1-4, **characterized in that** the pins (31) are fixed in sleeves (30) of the multifunction button (7).

6. Remote control according to any one of claims 1-5, **characterized in that** four magnets (17) and four pins (31) with thickened heads (32) are arranged on the multifunction button (7), wherein the magnets (17) and the pins (31) are tangentially offset from one another.

7. Remote control according to any one of claims 1-6, **characterized in that** the carrying plate (16) is fixed to the upper housing side (2) or the lower housing side (3) or to a printed circuit board (13).

## Revendications

1. Télécommande avec un boîtier (1) et un bouton multifonction (7) qui a une pluralité de zones de boutons (8, 9, 10, 11) qui sont radialement décalées par rapport à un point central et qui peuvent être déplacées par rapport au boîtier (1), le bouton multifonction (7) présente une pluralité de zones de boutons (8, 9, 19, 11) qui sont disposées décalées radialement par rapport à leur point central et qui comportent une pluralité d'aimants (17) qui sont associés à des contre-aimants (18) reliés au boîtier (1),
**caractérisé en ce que**
- les aimants (17) et contre-aimants (18) sont polarisés et disposés de manière à ce que le bouton multifonction (7) soit repoussé dans une première direction vers l'extérieur du boîtier (1),
- plusieurs broches (31) à tête épaissie (32) sont fixées au bouton multifonction (7),
- une plaque d'appui (16) fixée au boîtier comporte des coquilloe de coussinets (33) adaptés aux têtes épaissies (32),
- les broches (31) s'étendent à travers des ouvertures (34) de la plaque d'appui (16)
- et les coquilles de coussinets (33) et les têtes épaissies (32) sont conçues comme des butées de limite de course pour le déplacement du bouton multifonction (7) dans le sens inverse du premier sens.

2. Télécommande selon la revendication 1, **caractérisée en ce que** le bouton multifonction (7) a la forme d'un anneau circulaire.

3. Télécommande selon l'une des revendications 1, **caractérisée en ce que** le bouton multifonction (7) a la forme d'une croix.

4. Télécommande selon l'une des revendications 1 à 3, **caractérisée en ce que** les têtes épaissies (32) sont en forme de segment sphérique.

5. Télécommande selon l'une quelconque des revendications 1 à 4, **caractérisée en ce que** les broches (31) sont fixées dans des manchons (30) du bouton multifonction (7).

6. Télécommande selon les revendications 1 à 5, **caractérisée en ce que** quatre aimants (17) et quatre broches (31) à tête épaissie (32) sont disposées sur le bouton multifonction (7), les aimants (17) et les broches (31) sont décalés tangentiellement l'un à l'autre.

7. Télécommande selon l'une des revendications 1 à 6, **caractérisée en ce que** la plaque d'appui (16) sur le dessus du boîtier (2) ou le fond du boîtier (3) ou sur une carte de circuit imprimé (13) est fixe.
